# DEMANDE DE BREVET EUROPEEN

(11) **EP 2 800 135 A1**
(43) Date de publication de la demande: **05.11.2014**
(21) Numéro de dépôt: 14166685.9
(22) Date de dépôt: 30.04.2014
(51) Int. Cl.: H01L 27/12, H01L 21/84, H01L 29/78, H01L 29/786

(54) **Transistors à nanofils et planaires cointegrés sur substrat soi UTBox**

(30) Priorité: 02.05.2013 FR 1354045
(71) Demandeur: Commissariat à l'Énergie Atomique et aux Énergies Alternatives, 75015 Paris (FR); STMicroelectronics (Crolles 2) SAS, 38920 Crolles (FR)
(72) Inventeur: Barraud, Sylvain, 38690 Le Grand Lemps (FR); Morand, Yves, 38000 Grenoble (FR)
(74) Mandataire: Ilgart, Jean-Christophe

(57) **Abrégé**

Réalisation d'un dispositif microélectronique sur un substrat de type semi-conducteur sur isolant, le dispositif étant doté d'un transistor d'un type donné dont la structure de canal est formée de barreau(x) semi-conducteur(s), une zone diélectrique différente de la couche isolante du substrat étant prévue, en remplacement de la couche isolante, en regard de la structure de canal du transistor, spécifiquement pour ce type donné de transistor.

## Description

### DOMAINE TECHNIQUE

La présente invention a trait au domaine de la micro-électronique, et se rapporte plus particulièrement à celui de la réalisation de transistors dont la structure semi-conductrice du canal est sous forme d'une pluralité de nano-fils semi-conducteurs parallèles juxtaposés sur un substrat de type semi-conducteur sur isolant.

Elle prévoit notamment de réaliser des transistors de type différents sur un même substrat semi-conducteur sur isolant dont une ou plusieurs régions ont été modifiées.

L'invention s'applique par exemple à la mise en oeuvre de transistors de type finFET ou trigate co-intégrés sur un même substrat semi-conducteur sur isolant que des transistors à grille planaire de type FDSOI.

### ART ANTERIEUR

Afin notamment d'augmenter la densité d'intégration par rapport aux transistors MOSFET classiques, de nouvelles structures de transistors dont le canal est formé d'un ou plusieurs barreaux semi-conducteurs parallèles sont apparues.

Les transistors de type communément appelé « finFET » comportent par exemple un canal formé d'un ou de plusieurs barreaux ou ailerons semi-conducteurs sous forme de nano-fils juxtaposés qui s'étendent parallèlement au substrat sur lequel ce ou ces nano-fils est ou sont disposé(s).

Le document « Spacer FinFET: nanoscale double-gate CMOS technology for the terabit era » de Choi et al., Solid-State Electronics, vol. 46, pp. 1595-1601, 2002) divulgue par exemple un procédé de réalisation d'un transistor finFET à nano-fils de taille réduite obtenus par gravure à travers un masque dont les motifs, appelés « espaceurs », sont formés par dépôt conforme d'une couche contre un plot sacrificiel ayant une épaisseur inférieure à la dimension critique du plot.

La structure de grille de transistors à nano-fils est généralement non-planaire et prévue de manière à enrober le ou les nanofils, et en particulier à s'étendre sur les faces latérales des nano-fils.

Le transistor de type communément appelé « Trigate » a par exemple une structure de grille partiellement enrobante autour d'un ou plusieurs nano-fil(s) qui est agencée contre les flancs du ou des nano-fil(s) ainsi que sur leur face supérieure.

Le document US 6°914°295 B2 divulgue par exemple un procédé de réalisation d'un tel transistor tri-Gate.

Par rapport à une structure de grille planaire pour laquelle la grille s'étend uniquement dans une direction parallèle au canal, la surface de contact grille-canal est améliorée, ce qui a pour principal avantage de réduire les courants de fuite lorsque le transistor est à l'état bloqué ou « off ». On peut ainsi prévoir des longueurs de grille plus petites qu'avec des architectures de grille planaires tout en conservant des performances électriques identiques.

Par ailleurs, dans le domaine des transistors à structure de grille planaire, les transistors de type communément appelés FDSOI (FDSOI pour « Fully Depleted Silicon On insulator »), réalisés sur un substrat de type semi-conducteur sur isolant ont pour avantage par rapport aux transistors MOS classiques de pouvoir présenter une tension de seuil V_{T} modulable par couplage électrostatique encore appelé couplage capacitif.

Pour cela, on fait varier le potentiel appliqué sur la couche de support semi-conductrice du substrat de type semi-conducteur sur isolant sur lequel ces transistors sont formés.

Pour permettre d'obtenir un couplage entre cette couche de support et le canal des transistors, on peut mettre en oeuvre un substrat SOI avec une couche mince ou ultra-mince d'oxyde enterré (BOX ou « burried oxide » selon la terminologie anglo-saxonne).

Cependant, cette couche isolante peut s'avérer inadaptée pour des transistors à nano-fils.

Il se pose le problème de trouver un nouveau procédé de réalisation d'une structure de transistor à nano-fils semi-conducteurs, qui permette de pouvoir co-intégrer cette structure sur un substrat de type semi-conducteur sur isolant, avec un ou plusieurs transistors de type différent en particulier de type planaire(s).

### EXPOSÉ DE L'INVENTION

La présente invention prévoit la réalisation d'un dispositif microélectronique sur un substrat de type semi-conducteur sur isolant comprenant la formation d'au moins une structure de canal d'au moins un transistor d'un premier type, ladite structure étant formée d'un ou plusieurs barreau(x) semi-conducteur(s) juxtaposés, sur une zone diélectrique donnée qui est différente du reste de la couche isolante du substrat.

Par substrat de type semi-conducteur sur isolant, on entend un substrat comportant une couche de support semi-conductrice, une couche isolante sur ladite couche de support et ladite fine couche semi-conductrice reposant sur ladite couche isolante.

Pour obtenir la zone diélectrique donnée, le matériau de ladite couche isolante du substrat est tout d'abord retiré dans une région dans laquelle lesdits barreaux semi-conducteurs sont situés.

Un remplacement par un matériau diélectrique donné peut être ensuite effectué afin de réaliser une zone diélectrique de remplacement différente du reste de ladite couche isolante du substrat, dont l'épaisseur et la composition peuvent être adaptées spécifiquement au premier type de transistor.

Ainsi, la présente invention concerne un procédé de réalisation d'un dispositif microélectronique comprenant des étapes de :
a) réalisation, par gravure à travers une ouverture d'un premier masque située en regard d'une région donnée d'une fine couche semi-conductrice d'un substrat semi-conducteur sur isolant, d'un ou plusieurs barreau(x) semi-conducteur(s) destinés à former au moins un canal ou plusieurs canaux de transistor(s) d'un premier type,
b) retrait d'une zone de ladite couche isolante dudit substrat dans le prolongement de ladite ouverture de manière à libérer lesdits barreaux semi-conducteurs.

Les barreaux semi-conducteurs sont également appelés « nano-fils » lorsqu'ils ont une dimension critique inférieure à 11ₗm.

La couche isolante est à base d'un matériau ayant une première constante diélectrique k₁. Selon une possibilité de mise en oeuvre, le matériau de la couche isolante peut être du SiO₂.

Avantageusement, le procédé comprend en outre, après l'étape b), une étape consistant à déposer en regard de ladite ouverture, un matériau diélectrique donné en remplacement de ladite zone de ladite couche isolante retirée à l'étape b). Ce matériau diélectrique de remplacement a une épaisseur et/ou une composition différente de l'épaisseur et/ou de la composition de ladite zone de ladite couche isolante retirée à l'étape b).

Ainsi, en regard des barreaux semi-conducteurs, on forme une zone diélectrique spécifique différente de la couche isolante initiale du substrat de type semi-conducteur sur isolant.

Avantageusement, le matériau diélectrique donné de remplacement est un matériau diélectrique ayant une composition et une épaisseur prévues pour permettre un couplage électrostatique ou capacitif entre ladite couche de support et lesdits barreau(x) semi-conducteur(s).

Selon une possibilité de mise en oeuvre du procédé, le matériau diélectrique donné de remplacement a une constante diélectrique k₂ telle que k₂ > k₁.

Ce matériau diélectrique donné de remplacement peut être en particulier du SiₓN_{y} ou un diélectrique de type « high-k ».

Avantageusement, au moins une tranchée d'isolation entre ladite région donnée et la dite autre région de la fine couche semi-conductrice peut être réalisée. Cette tranchée d'isolation peut être de type STI (STI pour « Shallow Trench Isolation » ou tranchée d'isolation peu profonde).

Avantageusement, le ou les barreau(x) semi-conducteur(s) sont formés à l'étape a) par gravure de la fine couche semi-conductrice à travers un ou plusieurs blocs d'un deuxième masque recouvrant partiellement ladite ouverture dudit premier masque, et réalisé par :
- formation d'un ou plusieurs plots sacrificiels de dimension critique Dc₁ donnée sur ladite région donnée,
- formation d'un ou plusieurs blocs de dimension critique Dc2<Dc1 contre des flancs dudit ou desdits plots,
- retrait dudit ou desdits plots sacrificiel(s).

On peut réaliser ainsi des barreaux semi-conducteurs de faible taille.

Le procédé peut comprendre en outre, préalablement à la réalisation dudit masque, le dépôt d'une couche de masque dur sur ledit premier masque et dans ladite ouverture.

Dans ce cas, la réalisation dudit deuxième masque peut comprendre en outre la gravure anisotrope de la couche de masque dur à travers lesdits blocs de dimension critique Dc2.

Les blocs du deuxième masque peuvent avoir une extrémité reposant sur le premier masque et qui est située à l'extérieur d'une région délimitée par ladite ouverture dudit premier masque. Cette disposition peut permettre de faciliter un retrait ultérieur du deuxième masque.

Selon une possibilité de mise en oeuvre du procédé, à l'étape b) une autre zone de ladite couche isolante située en regard d'une autre région de ladite fine couche semi-conductrice peut être protégée par ledit premier masque et conservée.

En regard de cette autre zone, au moins un transistor d'un deuxième type, différent dudit premier type peut être alors prévu.

Ladite autre zone de ladite couche isolante qui a été conservée peut avoir une épaisseur et une composition adaptées au deuxième type de transistor.

Ainsi, selon l'invention, une co-intégration de transistors du premier type dont le canal est formé de barreaux parallèles juxtaposés en regard de ladite zone diélectrique spécifique, et d'au moins un transistor d'un deuxième type, différent du premier type, en regard de ladite zone conservée intacte de ladite couche isolante peut être réalisée.

Le transistor du premier type peut être par exemple un transistor de type tri-gate ou finFET à structure de grille enrobante, tandis que le ou les transistors du deuxième type peut ou peuvent être par exemple des transistors MOS à structure de grille planaire.

Avantageusement, ladite couche isolante du substrat peut être fine ou ultrafine et avoir une épaisseur inférieure à 20 nm. Ainsi, selon une possibilité de mise en oeuvre, le ou les transistors du deuxième type peut ou peuvent être par exemple de type FDSOI.

Selon un autre aspect, la présente invention concerne également un dispositif microélectronique doté :
- d'un substrat comprenant une fine couche semi-conductrice reposant sur une couche isolante, ladite couche isolante reposant sur une couche de support semi-conductrice,
- d'au moins un premier transistor d'un premier type comprenant une région adaptée à former un canal formé d'un ou plusieurs barreaux juxtaposés dans et/ou sur ladite fine couche semi-conductrice et une grille enrobante disposée sur lesdits barreaux et autour des faces latérales desdits barreaux, ledit canal dudit premier transistor étant disposé au-dessus et en regard d'une zone modifiée du substrat, ou sur une zone modifiée du substrat à base d'un matériau diélectrique donné différent de celui de la couche isolante.

Le matériau diélectrique donné de la zone modifiée du substrat peut avoir une constante diélectrique k₂ tel que k₂>k₁ avec k₁ la constante diélectrique du matériau de ladite couche isolante.

Le matériau diélectrique donné de la zone modifiée du substrat peut également avoir une composition et une épaisseur prévues pour permettre un couplage capacitif entre ledit canal dudit premier transistor et ladite couche de support semi-conductrice.

Cela permet notamment de pouvoir moduler la tension de seuil dudit premier transistor.

La couche isolante du substrat peut être à base de SiO₂ et avoir une épaisseur inférieure à 25 nm ou à 20 nm. Ainsi, le substrat peut être doté d'une couche isolante de type UTBOX.

Avantageusement, le dispositif peut comprendre au moins un deuxième transistor dont la zone de canal est formée dans une région de la fine couche semi-conductrice disposée sur et en contact de ladite couche isolante du substrat.

La couche isolante peut avoir une composition et une épaisseur prévues pour permettre un couplage capacitif entre le canal dudit deuxième transistor et ladite couche de support semi-conductrice dudit substrat.

Avantageusement, le dispositif peut comprendre au moins un autre transistor dont la zone de canal est formée dans une région semi-conductrice disposée sur et contact de la couche de support semi-conductrice du substrat.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

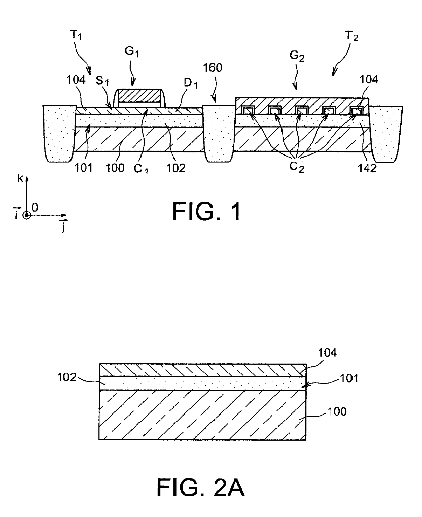

- la figure 1 illustre un exemple de dispositif microélectronique mis en oeuvre suivant l'invention sur un substrat semi-conducteur sur isolant, comprenant un transistor à nano-fils juxtaposés reposant sur une première région isolante et un transistor à structure de grille planaire reposant sur une deuxième région isolante appartenant à la couche isolante dudit substrat ;

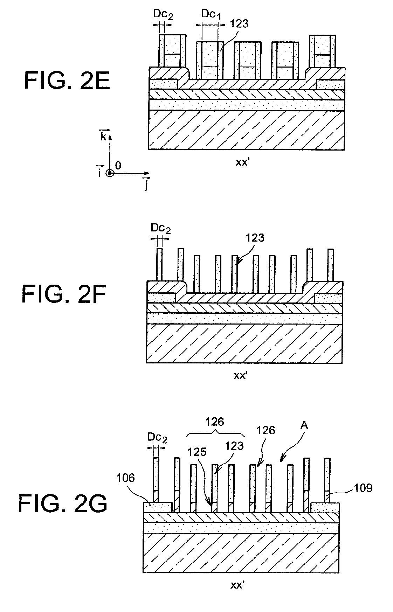

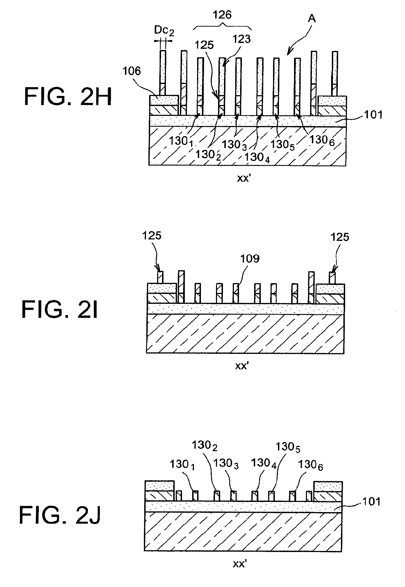

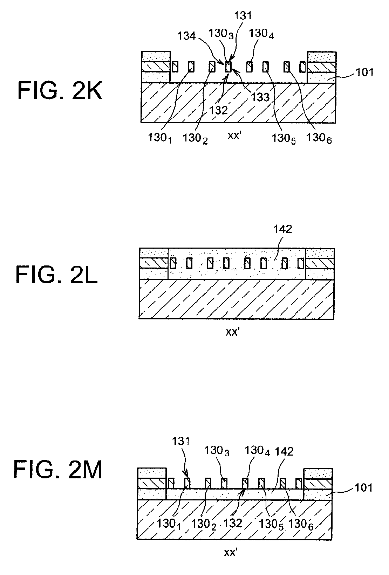

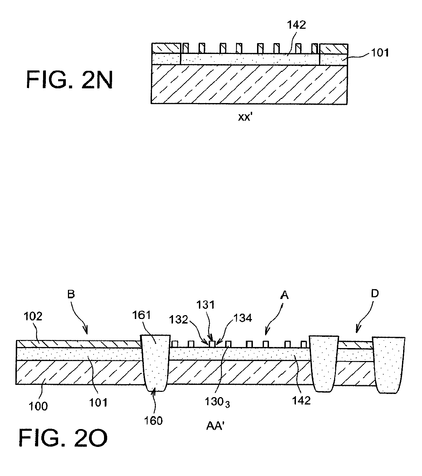

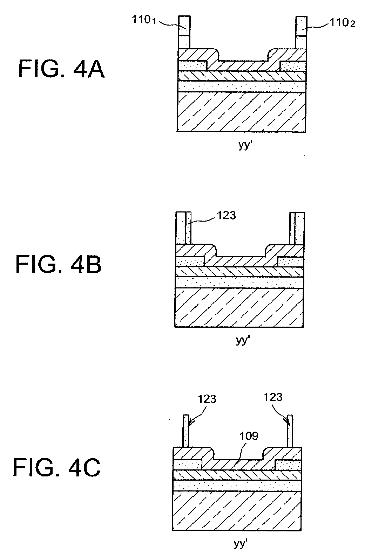

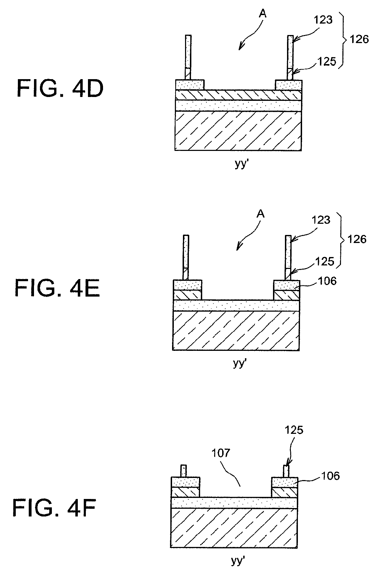

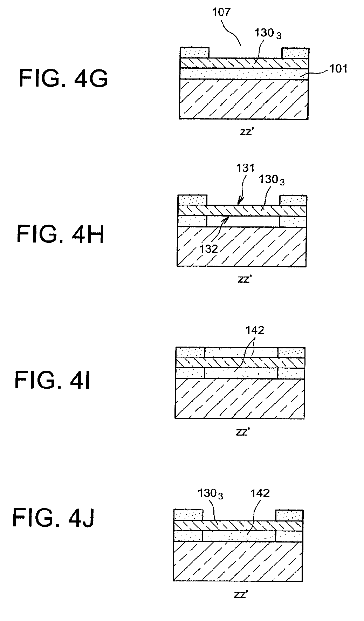

- les figures 2A-2O, 3A-3L, 4A-4J illustrent un exemple de procédé suivant l'invention de réalisation d'un dispositif microélectronique à transistors doté d'au moins un transistor à nano-fils et d'au moins un transistor à structure de grille planaire co-intégrés sur un substrat SOI ;

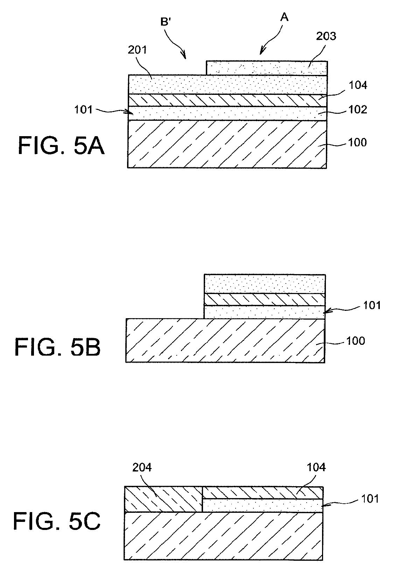

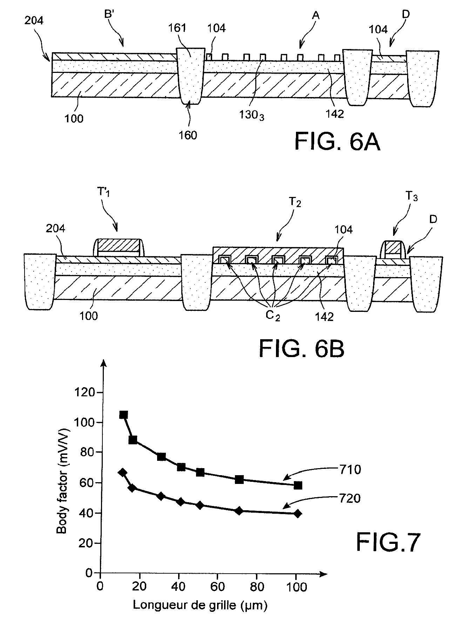

- les figures 5A-5C, et 6A-6B illustrent un exemple de réalisation d'un dispositif microélectronique à transistors doté d'au moins un transistor à nano-fils sur une zone diélectrique en remplacement de la couche isolante d'un substrat SOI d'un substrat et d'au moins un autre transistor sur une région semi-conductrice en remplacement de la fine couche semi-conductrice et de la couche isolante du substrat SOI ;
- la figure 7 donne des courbes d'évolution d'un paramètre illustrant une variation de tension de seuil d'un transistor à nano-fil sur une zone diélectrique de nitrure de silicium ou sur une zone d'oxyde de silicium en fonction de la longueur de sa grille ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

La figure 1 illustre un dispositif microélectronique formé à partir d'un substrat semi-conducteur sur isolant comprenant une couche de support semi-conductrice 100, une fine couche isolante 101 disposée sur et en contact de la couche de support semi-conductrice 100 et une fine couche semi-conductrice 104 disposée sur et en contact de la couche isolante 101.

Dans une première région du substrat, un transistor T₁ d'un type donné, par exemple MOSFET FDSOI comporte un canal C₁ et des régions de source S₁ et de drain D₁ formées dans ladite fine couche semi-conductrice 104. La grille G₁ de ce transistor a une structure planaire dans le sens où elle est sous forme d'une zone qui s'étend parallèlement au plan principal du substrat et parallèlement à la zone de canal C₁.

Le plan principal du substrat est défini ici et dans tout le reste de la description comme un plan passant par le substrat et parallèle au plan [O ; *i̅*; *j̅*] du repère [O ; *i̅* ; *j̅* ; *k̅*] indiqué sur la figure 1.

La zone de canal C₁ du transistor T₁ est disposée sur et en contact d'une zone de ladite couche isolante à base d'un matériau diélectrique 102 de constante diélectrique k₁ et séparée de la couche de support 100 par cette zone.

La zone de la couche isolante 101 séparant le canal C₁ de la couche 100 de support est prévue dans cet exemple avec une composition et une épaisseur permettant de mettre en oeuvre un couplage capacitif entre le canal C₁ et ladite couche de support semi-conductrice. Ce couplage peut être tel qu'une variation de potentiel appliqué sur la couche 100 entraine une variation de la tension de seuil V_{T1} du transistor T₁ de l'ordre par exemple de 100mV.

La couche isolante 101 peut être par exemple à base de SiO₂ et d'épaisseur inférieure à 20 nm.

Dans une deuxième région du substrat séparée de la première région par des tranchées d'isolement 160 de type STI (de l'anglais Shallow Trench Isolation), un transistor T₂ d'un type différent, par exemple de type communément appelé « finFET » ou de type communément appelé « triGate » comporte un canal C₂ formé d'une pluralité de barreaux semi-conducteurs ou « nano-fils » réalisés par gravure de ladite fine couche semi-conductrice 104, et qui sont donc juxtaposés dans un même plan parallèle au plan principal du substrat. La grille G₂ de ce transistor T₂ a une structure enrobante et recouvre les faces latérales (dans cet exemple des faces orthogonales au plan [O ; *i̅* ; *k̅*]) et la face supérieure des nano-fils (dans cet exemple une face parallèle au plan [O ; *i̅*; *j̅*]).

Le canal C₂ du transistor T₂ est disposé sur et en contact d'une zone à base d'un matériau diélectrique 142 différent du matériau 102 de la zone en regard de laquelle se trouve le premier transistor T₁ et de constante diélectrique k₂ telle que k₂> k₁.

La zone de matériau diélectrique 142 séparant le canal C₂ de la couche 100 de support est prévue, dans cet exemple, avec une composition et une épaisseur permettant de mettre en oeuvre un couplage capacitif entre ce canal C₂ et ladite couche de support semi-conductrice.

La constante diélectrique k₂ du matériau diélectrique 142 est supérieure à celle k₁ du diélectrique 102 afin de permettre un meilleur couplage capacitif entre le canal C₂ et le substrat.

La zone de matériau diélectrique 142 peut être par exemple à base de Si₃N₄ ou d'un matériau diélectrique high-k tel que du HfO₂ ou du HfSiOₓN_{y} et d'épaisseur inférieure à 25 nm ou à 20 nm.

Le couplage capacitif entre le canal C2 et le substrat est tel qu'une modulation de la tension de seuil peut être mise en oeuvre. Une modulation apparait dès lors que le couplage capacitif entre le canal et le substrat devient du même ordre de grandeur que le couplage entre la grille et le canal, le substrat agissant ainsi à la façon d'une seconde grille.

Le couplage entre le canal C₂ et la couche 100 peut être tel qu'une variation de potentiel appliquée sur la couche 100 entraine une variation de la tension de seuil V_{T2} du transistor T₂ qui peut atteindre plusieurs dizaines de mV, par exemple 100 mV.

La figure 7 donne un exemple de courbe 710 d'évolution d'un paramètre communément appelé « body factor» correspondant à une variation de la tension de seuil d'un transistor ayant un agencement semblable à celui du transistor T₂ mais doté d'un seul barreau semi-conducteur de hauteur de l'ordre de 15 nm, de largeur de l'ordre de 15 nm, en fonction d'une variation du potentiel de la couche 100 du substrat obtenue dans un cas où le matériau diélectrique 142 est du nitrure de silicium de constante diélectrique k=7. A titre de comparaison une courbe 720 illustre l'évolution du body factor pour ce transistor, lorsque le matériau diélectrique 142 est remplacé par du SiO₂.

Un tel type de dispositif peut être appliqué à la réalisation d'un circuit logique à haute performance et basse consommation.

Un exemple de procédé de réalisation d'un dispositif microélectronique à transistors, va être décrit en liaison avec les figures 2A-2O (sur lesquelles le dispositif en cours de réalisation est représenté selon une vue en coupe transversale XX'), les figures 3A-3L (sur lesquelles le dispositif en cours de réalisation est représenté selon une vue de dessus), les figures 4A-4J (sur lesquelles le dispositif en cours de réalisation est représenté selon une vue en coupe transversale Y'Y ou Z'Z).

Le matériau de départ de ce procédé (figure 2A) peut être un substrat de type semi-conducteur sur isolant formé de la couche de support 100 à base de matériau semi-conducteur, par exemple du silicium, la couche de support étant recouverte de la couche isolante 101 à base du matériau diélectrique 102, de constante diélectrique k₁ par exemple du SiO₂, elle-même recouverte de la fine couche semi-conductrice 104.

La couche isolante 101 peut être en particulier une couche mince ou ultra-mince de type communément appelé « thin-BOX » (BOX pour « Burried Oxide ») ou « ultra-thin BOX» (UTB), et ainsi avoir une épaisseur qui peut être inférieure à plusieurs dizaines de nanomètres ou à 20 nm, par exemple de l'ordre de 10 nm.

La fine couche semi-conductrice 104 peut être par exemple à base de Ge ou de SiGe, ou de Si, en particulier d'orientation <100> ou <110> et avoir une épaisseur qui peut être inférieure à 20 nm, par exemple de l'ordre de 12 nm.

Dans une première région A du substrat, et en particulier de la couche 104, au moins un transistor d'un type donné, par exemple de type « finFET » ou « trigate », doté d'un canal sous forme d'un ou plusieurs barreaux parallèles juxtaposés, est destiné à être réalisé, tandis que dans une ou plusieurs autre(s) région(s) (non représentée(s) sur la figure 2A) un ou plusieurs transistors de type différent, par exemple de type à structure de grille planaire sont destinés à être formés.

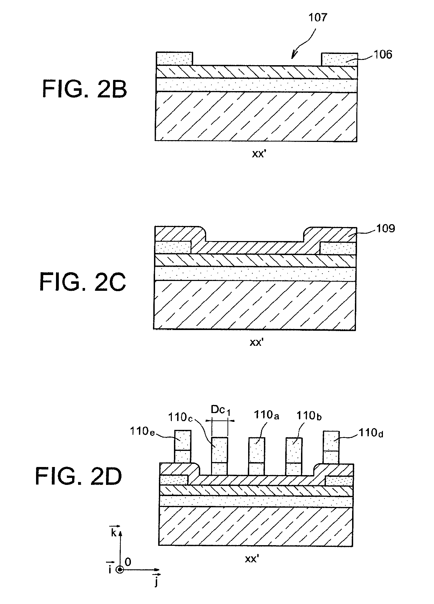

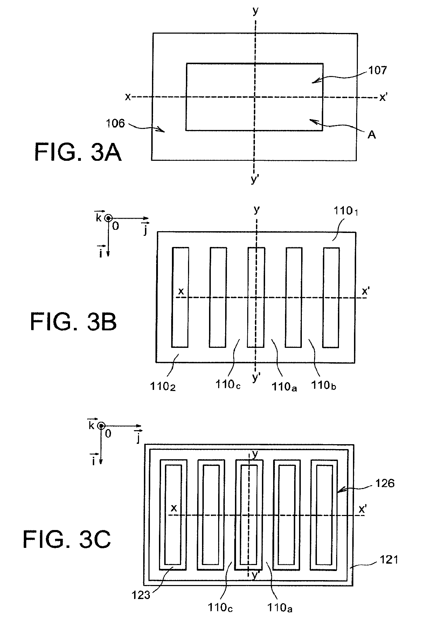

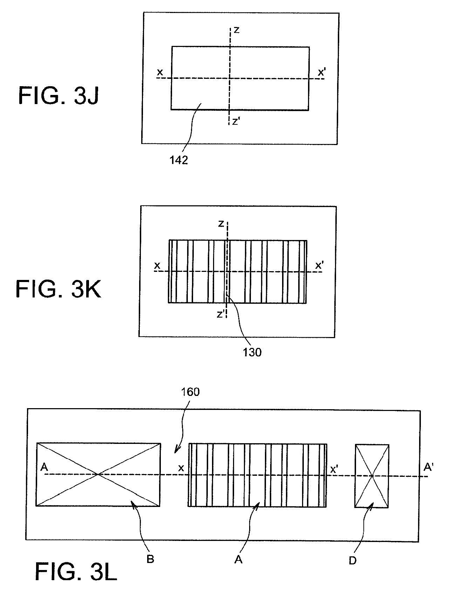

Sur le substrat 100, on forme tout d'abord un premier masque 106 comprenant une ouverture 107 délimitant la première région A et dévoilant la fine couche semi-conductrice 104. Le premier masque 106 peut être par exemple à base de nitrure de silicium et avoir une épaisseur comprise par exemple entre plusieurs nanomètres et plusieurs dizaines de nanomètres, par exemple de l'ordre de 30 nm (figures 2B et 3A).

Ensuite, on forme une couche 109 dite de « masque dur », par exemple à base d'un métal tel que du TiN, de manière à recouvrir de manière conforme le premier masque 106 et la première région A de la fine couche semi-conductrice 104 dévoilée par l'ouverture 107. La couche 109 de masque dur a une épaisseur qui peut être comprise entre plusieurs nanomètres ou dizaines de nanomètres, par exemple de l'ordre 10 nm (figure 2C).

Puis (figures 3B, 2D, et 4A), on réalise un bloc sacrificiel par exemple par dépôt d'un empilement d'une couche à base de carbone réalisée par dépôt SoC (pour « Spin On Carbon ») et de Si-Arc et d'une résine que l'on insole par exemple à l'aide d'un faisceau d'électrons (« e-beam » selon la terminologie anglo-saxonne) puis que l'on grave ensuite.

Le bloc sacrificiel est composé de premiers plots 110a, 110b, 110c, 110d, 110e, parallélépipédiques parallèles entre eux et juxtaposés, ces premiers plots s'étendant dans une première direction (la première direction étant dans cet exemple celle du vecteur *i̅* du repère [O ; *i̅* ; *j̅* ; *k̅* ] donné sur les figures 3B et 2D) parallèle au plan principal du substrat. Le bloc sacrificiel est également composé de deuxièmes plots parallélépipédiques 110₁, 110₂, joignant les extrémités des premiers plots 110a, 110b, 110c, 110d, 110e, et s'étendant dans une deuxième direction (dans cet exemple celle du vecteur *j̅*), orthogonale à ladite première direction.

Certains plots 110a, 110b, 110c ont une portion formée en regard de l'ouverture 107 du masque 106 dévoilant la première région A de la fine couche semi-conductrice 104, tandis que d'autres blocs 110d, 110e, 110₁, 110₂ sont disposés autour de ladite première région A et en regard du masque 106.

Les plots 110a, 110b, 110c, 110d, 110e, 110₁, 110₂, formant le bloc sacrificiel peuvent avoir une dimension critique Dc₁ par exemple de l'ordre de 20 nm (la dimension critique étant définie ici et tout au long de la description comme la plus petite dimension d'un élément mesurée dans un plan parallèle au plan principal du substrat, i.e. parallèle au plan [O ; *i̅* ; *i̅* ; *j̅* ] donné par exemple sur la figure 3B).

On réalise ensuite un dépôt conforme d'un matériau 121, qui peut être diélectrique et par exemple à base de nitrure de silicium, et recouvre notamment les flancs ou faces latérales de ces plots 110a, 110b, 110c, 110d, 110e, et 110₁, 110₂.

L'épaisseur de matériau 121 déposée peut être par exemple de l'ordre de 10 nm.

Par retrait partiel du matériau 121, on forme des blocs 123 de masquage également appelés « espaceurs » 123, contre les flancs latéraux du bloc sacrificiel et entourant ce dernier. Ces espaceurs 123 ont une dimension critique Dc₂, par exemple de l'ordre d'une dizaine de nanomètres, plus faible que la dimension critique Dc₁ des plots formant le bloc sacrificiel et pouvant être sensiblement égale à l'épaisseur déposée de matériau 121 (figures 3C, 2E, 4B). Les espaceurs 123 peuvent être réalisés par gravure avec arrêt sur la couche de masque dur 109. Dans le cas, par exemple, où les espaceurs 123 sont à base de nitrure et la couche de masque dur 109 est à base d'un métal tel que le TiN cette gravure peut être effectuée à l'aide d'un plasma N₂O₂ par exemple.

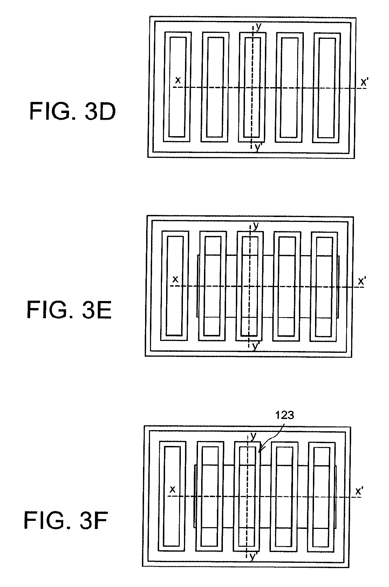

On effectue ensuite un retrait du bloc sacrificiel, tandis que les espaceurs 123 sont quant à eux conservés (figures 3D, 2F, 4C). Pour cela, une gravure plasma O₂ peut être réalisée.

On reproduit ensuite (figures 3E, 2G, 4D) les motifs des espaceurs 123 dans la couche 109 de masque dur. On forme ainsi dans cette couche 109 des blocs 125 de masque dur dans le prolongement des espaceurs 123. Ces blocs 125 sur lesquels reposent les espaceurs 123 ont des dimensions et en particulier une dimension critique sensiblement égale à celle Dc₂ des espaceurs 123. Cette étape peut être réalisée par le biais d'une gravure anisotrope de la couche de masque dur 109 par exemple à l'aide de BCl_{3/}Cl₂. On dévoile ainsi à nouveau le premier masque 106, ainsi que la première région A de la fine couche semi-conductrice 104 du substrat.

Les blocs 125 surmontés des espaceurs 123 forment un deuxième masque 126 disposé au-dessus du premier masque 106, et dont des portions sont situées en regard et recouvrent partiellement l'ouverture 107 du premier masque 106.

On peut ensuite reproduire les motifs du deuxième masque 126 dans la fine couche semi-conductrice 104 (figures 3F, 2H, 4E), afin de former des barreaux semi-conducteurs 130₁, 130₂, 130₃, 130₄, 130₅, 130₆, encore appelés « fils » (ou nano-fils lorsque leur dimension critique est inférieure à 1 µm), ou « ailettes » (« fin » selon la terminologie anglo-saxonne), de dimension critique Dc₃ sensiblement égale à Dc₂. Les barreaux semi-conducteurs 130₁, 130₂, 130₃, 130₄, 130₅, 130₆ réalisés peuvent ainsi avoir une dimension critique Dc₃ telle que Dc₃ ≈ Dc₂ et de l'ordre de plusieurs nanomètres, par exemple de l'ordre de 10 nm. Les barreaux semi-conducteurs 130₁, 130₂, 130₃, 130₄, 130₅, 130₆, juxtaposés peuvent être répartis selon un pas par exemple de l'ordre de 35 nm.

Pour réaliser cette étape, une gravure anisotrope est effectuée à travers le premier masque 106 et le deuxième masque 126 en s'arrêtant sur la fine couche isolante 101 du substrat. Cette gravure peut être réalisée par exemple à l'aide de CF₄ et de HBr/O₂.

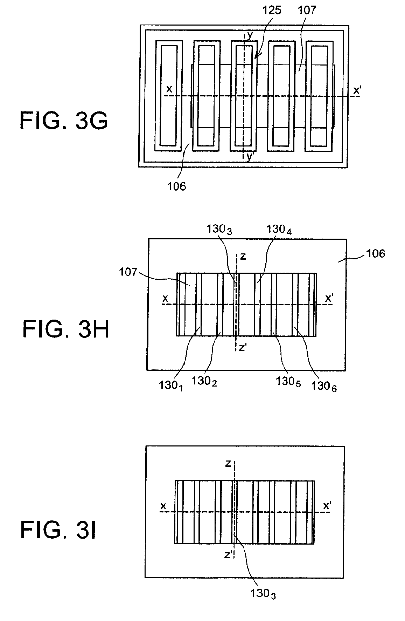

On peut ensuite retirer le deuxième masque 126. Pour cela, on peut effectuer tout d'abord un retrait des espaceurs 123 (figures 3G, 2I, 4F), par exemple par gravure à l'aide de HF.

Puis, (figures 3H, 2J, 4G, la figure 4G illustrant cette fois une vue en coupe transversale ZZ' indiquée sur la figure 3H), on retire ensuite les blocs 125 de la couche de masque dur 109, pour ne conserver que les barreaux semi-conducteurs 130₁, 130₂, 130₃, 130₄, 130₅, 130₆.

On effectue ensuite un retrait de la fine couche isolante 101 du substrat en regard de la première région A et à travers l'ouverture 107 du premier masque 106 (figures 3I, 2K, 4H). Ce retrait peut être réalisé par exemple par gravure chimique à l'aide de HF. A l'issue de ce retrait, une portion des barreaux semi-conducteurs 130₁, 130₂, 130₃, 130₄, 130₅, 130₆ située dans la première région A est libérée. Les barreaux semi-conducteurs 130₁, 130₂, 130₃, 130₄, 130₅, 130₆ sont ainsi suspendus et maintenus par des zones de la fine couche semi-conductrice 104 non-gravées et situées à l'extérieur de la première région A délimitée par l'ouverture 107 du premier masque 106. Les portions des barreaux semi-conducteurs 130₁, 130₂, 130₃, 130₄, 130₅, 130₆ libérées ont des faces supérieure 131, inférieure 132 et latérales 133, 134 dévoilées dans le prolongement de l'ouverture 107.

On peut effectuer ensuite un dépôt d'un matériau diélectrique 142 différent de celui 102 de la fine couche isolante 101. Le matériau diélectrique 142 peut en particulier avoir une constante diélectrique k₂ supérieure à celle k₁ de la fine couche isolante 101 du substrat. Le matériau diélectrique 142 déposé peut être par exemple un nitrure de silicium ou un matériau de type communément appelé « high-k ». Le dépôt peut être éventuellement réalisé de manière à combler l'ouverture 107 du masque dur 106 et éventuellement entourer les barreaux semi-conducteurs 130₁, 130₂, 130₃, 130₄, 130₅, 130₆. Dans ce cas, une étape de polissage communément appelée « planarisation » ou CMP (CMP pour « Chemical Mechanical Polishing ») on effectue alors un retrait du matériau diélectrique 142 située au dessus de la face supérieure du premier masque 106 (figures 3J, 2L, 4I).

Un retrait partiel du matériau diélectrique 142 est ensuite effectué de manière à dévoiler la face supérieure 131 et les faces latérales 133, 134, des barreaux 130₁, 130₂, 130₃, 130₄, 130₅, 130₆ semi-conducteurs.

Ce retrait partiel peut être éventuellement effectué jusqu'à atteindre le niveau de la face supérieure des zones restantes de la fine couche isolante 101, correspondant au niveau de la face inférieure 132 des barreaux 130₁, 130₂, 130₃, 130₄, 130₅, 130₆. Dans ce cas, la zone de matériau diélectrique 142 réalisée sous et en regard des barreaux 130₁, 130₂, 130₃, 130₄, 130₅, 130₆.a une épaisseur sensiblement égale à celle de la couche isolante 101.

La zone restante de matériau diélectrique 142 remplace alors la région de la fine couche isolante 101 de BOX qui a été retirée auparavant. La zone de matériau diélectrique 142 de remplacement s'étend notamment le long des barreaux et est prévue en termes d'épaisseur et de composition pour permettre d'établir un couplage capacitif entre le substrat 100 et les barreaux 130₁, 130₂, 130₃, 130₄, 130₅, 130₆. Ensuite, on effectue un retrait du premier masque 106, par exemple à l'aide de HF (figures 2M, 3K, 4J).

On forme ensuite des zones d'isolation, par exemple de type STI autour de la première région A et d'autres régions B et D de la fine couche semi-conductrice 104 dans lesquelles d'autres structures de transistors ont été réalisées ou sont destinées à être réalisées.

Les zones d'isolation peuvent être réalisées par formation de tranchées 160 autour des régions A, B, D, puis par dépôt d'un matériau diélectrique 161 tel que du SiO₂ dans ces tranchées 160.

Sur la figure 2O, une première zone d'isolation sépare la première région A dans laquelle les barreaux semi-conducteurs 130₁, 130₂, 130₃, 130₄, 130₅, 130₆ ont été réalisés d'une deuxième région B dans laquelle des transistors à structure de grille planaire, par exemple de type FDSOI, sont destinés à être réalisées ou en cours de formation.

Une deuxième zone d'isolation sépare la première région A d'une troisième région D dans lesquelles un ou plusieurs autres structures ou composants ont été réalisées ou sont destinées à être réalisées.

Ensuite, des étapes de dépôt d'un diélectrique de grille, puis d'un matériau de grille sur les barreaux semi-conducteurs 130₁, 130₂, 130₃, 130₄, 130₅, 130₆ et sur la région B de la fine couche semi-conductrice 104, ainsi qu'une gravure de ce diélectrique de grille et de ce matériau de grille peuvent être effectuées.

On forme ainsi des grilles de transistors, et notamment une ou plusieurs grille(s) de type planaire qui s'étendent parallèlement à la fine couche semi-conductrice 104 du substrat dans la deuxième région B et au moins une grille enrobante disposée autour des faces latérales 133, 134 et sur la face supérieure des barreaux semi-conducteurs 130₁, 130₂, 130₃, 130₄, 130₅, 130₆.

Une variante de réalisation est illustrée sur les figures 5A-5C et 6A-6B.

Pour cette variante, le matériau de départ peut être le substrat de type semi-conducteur sur isolant de l'exemple de procédé précédemment décrit, formé de la couche de support 100 à base de matériau semi-conducteur, recouverte de la couche isolante 101 à base de matériau diélectrique 102, de constante diélectrique k₁, elle-même recouverte de la fine couche semi-conductrice 104.

Dans une première région A de la couche 104, un transistor d'un type donné, par exemple de type « finFET » ou « trigate », doté d'un canal sous forme de barreaux parallèles juxtaposés, est destiné à être réalisé, tandis que dans une autre région B', au moins un transistor de type différent, par exemple de type à structure de grille planaire est destiné à être formé.

On réalise tout d'abord une couche de masque dur 201, par exemple à base d'oxyde de silicium de type TeOS, sur la fine couche semi-conductrice 104.

Puis, un masque 203, par exemple à base de résine photosensible en regard de la première région A de la fine couche semi-conductrice 104 est ensuite formé sur la couche de masque dur 203, l'autre région B' étant quant à elle dévoilée (figure 5A).

On effectue ensuite une gravure de la couche de masque dur 201, de la fine couche semi-conductrice 104, et de la couche isolante 101 à travers le masque 203.

On retire ainsi la couche isolante 101 dans l'autre région B' du substrat, de manière à dévoiler une zone de la couche de support 101 située dans cette deuxième région du substrat de type semi-conducteur sur isolant (figure 5B).

On peut ensuite retirer le masque 203 de résine, puis former une région semi-conductrice 204 sur la zone dévoilée de la couche de support 101. Cette région semi-conductrice 204 peut être réalisée par exemple par croissance par épitaxie (figure 5C).

Dans l'autre région B' du substrat, la région semi-conductrice 204 forme ainsi une région modifiée de type substrat massif (« bulk » selon la terminologie anglo-saxonne). On ainsi formé un substrat de type semi-conducteur sur isolant modifié comportant une région semi-conductrice 204 reposant directement sur la couche de support 100.

Ensuite, on peut effectuer un procédé tel que décrit précédemment en liaison avec les figures 2A-2O, 3A-3L, 4A-4J, afin de former une structure de canal de transistor à barreaux 130₁, 130₂, 130₃, 130₄, 130₅, 130₆ dans la première région A (figure 6A).

On peut ainsi réaliser dans la première région A un transistor T₂ comportant un canal formé d'une pluralité de barreaux semi-conducteurs formées sur une zone à base du matériau diélectrique 142, différent de celui de la couche isolante 101 du substrat de type semi-conducteur sur isolant.

Dans l'autre région B' modifiée une structure de transistor planaire T'1 dont la structure de canal est située dans la région semi-conductrice 204 est formée. Les régions A et B' peuvent être co-intégrées avec une troisième région D du substrat semi-conducteur isolant dont la couche isolante 101 a été gardée intacte. Dans cette troisième région D, un transistor T₃ dont le canal est prévu dans la fine couche semi-conductrice 104 du substrat peut être formé (figure 6B).

## Revendications

1. Procédé de réalisation d'un dispositif microélectronique comprenant des étapes consistant à :
a) réaliser dans une première région (A) d'une fine couche semi-conductrice (104) d'un substrat située en regard d'une ouverture (107) d'un premier masque (106), un ou plusieurs barreau(x) semi-conducteur(s) (130₁,...,130₆) destinés à former au moins un canal ou plusieurs canaux de transistor(s) d'un premier type, ledit substrat étant un substrat de type semi-conducteur sur isolant comportant une couche de support (100) sur laquelle repose une couche isolante (101) à base d'un premier matériau (102) ayant une première constante diélectrique k₁, ladite fine couche semi-conductrice (104) reposant sur ladite couche isolante (101),
b) retrait d'une zone de la couche isolante (101) dans le prolongement de ladite ouverture (107) dudit premier masque (106) de manière à libérer lesdits barreaux semi-conducteurs (130₁,...,130₆).
c) remplacement de ladite zone retirée de ladite couche isolante par une zone de matériau diélectrique donné (142) ayant une deuxième constante diélectrique k₂ telle que k₂ > k₁.

2. Procédé de réalisation d'un dispositif microélectronique selon l'une des revendication 1, le matériau diélectrique donné (142) ayant une composition et une épaisseur prévues pour permettre un couplage capacitif entre ladite couche de support (100) et lesdits barreau(x) semi-conducteur(s) (130₁,...,130₆).

3. Procédé de réalisation d'un dispositif microélectronique selon l'une des revendications 1 ou 2, dans lequel la zone de matériau diélectrique (142) est formé de sorte à affleurer au niveau d'une face inférieure des barreaux semi-conducteurs située en regard de la couche de support (100).

4. Procédé de réalisation d'un dispositif microélectronique selon la revendication 1 à 3, dans lequel ledit ou lesdits un ou plusieurs barreau(x) semi-conducteur(s) sont formés à l'étape a) par gravure de la fine couche semi-conductrice à travers un ou plusieurs blocs d'un deuxième masque (126) recouvrant partiellement ladite ouverture (107) dudit premier masque (106), la réalisation du deuxième masque (126) comprenant des étapes consistant à:
- former un ou plusieurs plots sacrificiels (110) de dimension critique Dc1,
- former un ou plusieurs blocs (123) de masquage de dimension critique Dc2<Dc1 contre des flancs dudit ou desdits plots sacrificiel(s),
- retirer ledit ou lesdits plots sacrificiel(s).

5. Procédé de réalisation d'un dispositif microélectronique selon la revendication 4, dans lequel, la réalisation dudit deuxième masque (126) comprend en outre, après réalisation dudit premier masque (106) et préalablement à l'étape a), des étapes consistant à :
- déposer une couche (109) de masque dur sur ledit premier masque (106) et dans ladite ouverture (107),
- graver la couche (109) de masque dur à travers lesdits blocs (123) de dimension critique Dc₂ de manière à former des blocs de masque dur (125) dans le prolongement desdits blocs (123).

6. Procédé de réalisation d'un dispositif microélectronique selon l'une des revendications 4 ou 5, dans lequel lesdits blocs (123) sont disposés de manière à avoir des extrémités reposant sur ledit premier masque (106).

7. Procédé de réalisation d'un dispositif microélectronique selon l'une des revendications 1 à 6, comprenant en outre au moins une étape consistant à :
- réaliser au moins une tranchée d'isolation (160) entre ladite région donnée (A) et la dite autre région (B,C) de ladite fine couche semi-conductrice.

8. Procédé de réalisation d'un dispositif microélectronique selon l'une des revendications 1 à 7, ladite couche isolante (101) étant à base de SiO₂ et ayant une épaisseur inférieure à 20 nm.

9. Procédé de réalisation d'un dispositif microélectronique selon l'une des revendications 1 à 8, dans lequel à l'étape b) une autre zone de la couche isolante (101) située en regard d'une deuxième région (B) de ladite fine couche semi-conductrice (104) dans laquelle au moins un autre canal de transistor d'un deuxième type est destiné à être formé est conservée.

10. Procédé de réalisation d'un dispositif microélectronique selon l'une des revendications 1 à 8, comprenant en outre des étapes de :
- retrait d'une autre zone de la couche isolante (101) de manière à dévoiler une région donnée de la couche de support (100),
- croissance d'une région semi-conductrice (204) sur ladite région donnée de la couche de support (100), au moins un canal de transistor étant destiné à être formé dans ladite région semi-conductrice (204).

11. Procédé de réalisation d'un dispositif microélectronique selon l'une des revendications 1 à 10, dans lequel après l'étape c), on forme une grille enrobante sur lesdits barreaux et autour des faces latérales desdits barreaux.

12. Dispositif microélectronique comprenant :
- un substrat comprenant une fine couche semi-conductrice (104) reposant sur une couche isolante (101), ladite couche isolante reposant sur une couche de support (100) semi-conductrice,
- au moins un premier transistor (T₂) d'un premier type comprenant une région adaptée à former un canal (C₂), la région comprenant un ou plusieurs barreaux juxtaposés disposée dans et/ou sur ladite fine couche semi-conductrice (104) et une grille enrobante (G2) disposée sur lesdits barreaux et autour des faces latérales desdits barreaux, ledit canal dudit premier transistor étant agencé sur une zone à base d'un matériau diélectrique (142) donné différent de celui de ladite couche isolante,
ledit matériau diélectrique donné (142) ayant une composition et une épaisseur prévues pour permettre un couplage capacitif entre ledit canal (C2) dudit premier transistor (T₂) et ladite couche de support semi-conductrice dudit substrat et/ou ledit matériau diélectrique donné (142) ayant une constante diélectrique k₂ telle que k₂>k₁, avec k₁ la constante diélectrique du matériau (102) de couche isolante.

13. Dispositif microélectronique selon la revendication 12, ladite zone de ladite couche isolante étant à base de SiO₂ et ayant une épaisseur inférieure à 20 nm.

14. Dispositif microélectronique selon l'une des revendications 12 ou 13, comprenant au moins un deuxième transistor (T₃) dont la zone de canal est formée dans une région (C) de la fine couche semi-conductrice (104) disposée sur et en contact de la couche isolante (101) du substrat.

15. Dispositif microélectronique selon la revendication 14, ladite couche isolante (101) ayant une composition et une épaisseur prévues pour permettre un couplage capacitif entre le canal dudit deuxième transistor (T₃) et ladite couche de support semi-conductrice dudit substrat.

16. Dispositif microélectronique selon l'une des revendications 12 à 15, comprenant au moins un autre transistor (T'1) dont la zone de canal est formée dans une région semi-conductrice (204) disposée sur et contact de la couche de support semi-conductrice du substrat.
